# EUROPEAN PATENT APPLICATION

(11) **EP 2 816 625 A1**
(43) Date of publication of application: **24.12.2014**
(21) Application number: 13461533.5
(22) Date of filing: 21.06.2013
(51) Int. Cl.: H01L 51/42

(54) **Device capable of transforming infrared radiation into electrical current or electrical voltage, working at room temperature, and a method of fabrication of the said device**

(71) Applicant: Inphotech Sp. z o.o. (Ltd), 00-195 Warszawa (PL)
(72) Inventor: Bednorz, Mateusz Andrzej, 44-117 Gliwice (PL); Nasilowski, Tomasz, 00-124 Warszawa (PL); Pawlik, Katarzyna Joanna, 03-126 Warszawa (PL); Olszewska, Malgorzata, 02-726 Warszawa (PL); Tenederenda, Tadeusz, 02-796 Warszawa (PL); Napierala, Marek Adam, 54-129 Wroclaw (PL); Murawski, Michal, 03-341 Warszawa (PL); Szymanski, Michal, 03-910 Warszawa (PL); Holdynski, Zbigniew, 01-476 Warszawa (PL)
(74) Representative: Rumpel, Alicja

(57) **Abstract**

The device for transforming infrared radiation into electrical current or electrical voltage, especially working at room temperature according the invention that constitutes a hybrid semiconductor photodiode comprising of a combination of inorganic semiconducting material, for example silicon, and a semiconducting organic material, as well as appropriate metal electrodes providing an electrical contact of each of the parts of the junction with external electrical circuit separately is characterized in that, the organic material (2) is Quinacridone (5,12-Dihydro-quino[2,3-b]acridine-7,14-dione), and where top metal electrode (3) connecting the said organic layer (2) with the external electric circuit, has an area of 1mm² or lower.

The method of fabrication of the said device is characterized in that, the deposition of the organic layer (2) is realized by evaporation in a vacuum chamber by a process of hot-wall-epitaxy (HWE), and the evaporation is preceded by thermal annealing of the said silicon substrate in the chamber under high vacuum conditions at temperature of 610°C, for the duration of 10 min.

## Description

The subject of the invention is a device capable of transforming infrared radiation into electrical current or electrical voltage, working at room temperature, and a method of fabrication of the said device

The detection of light in the near infrared (NIR) and infrared (IR) spectral range is a technology demand in many different branches of modern industry. The most important are: optical data transmission, quality control and material identification in bioscience, chemical industry and food industry, etc. Moreover it is clear that the future development of optoelectronics technologies will feature an integration of optoelectronic building blocks, including photodetectors converting optical signals into electrical ones, into electronic integrated circuits (ICs) based on silicon.

The main limitation in straightforward integration of optoelectronic elements with silicon ICs is the transparency of silicon in near infrared and infrared spectral range. Therefore silicon is not a potential candidate for an optoelectronic active element in NIR and IR.

Presently used commercial photodetectors working in NIR and IR spectral range are mostly based on heterojunctions of compound semiconductors (predominantly InGaAs, AlGaAs, InSb) or photoconductors (PbSe, PbTe, PbS). They all feature high sensitivity, or broad frequency band. Nevertheless, they are all processed using advanced and high-energy input, ultra high vacuum microelectronic technologies, such as: molecular beam epitaxy (MBE) or metalorganic chemical vapor deposition (MOCVD), which are not compatible with integrated silicon circuit technologies.

Up to now, few publications report on infrared detector based on silicon, featuring for example: absorption via ions implanted into silicon (H⁺), or absorption via surface localized states in silicon dioxide. Both solutions exhibit a level of sensitivity similar to the proposed invention, additionally they require cooling. Other typical solution for commercial and military applications is a metal-silicon junction, for example NiSi₂/p-Si. Those detectors exhibit a satisfying sensitivity level, however, they require a high level of cleanness during the fabrication process as well as cooling due to high level of a dark current in the metal-semiconductor junction, due to the process of thermionic emission, which is characteristic for such a junctions.

Austrian Patent Application AT 50381 B1 describes a solution of a photodetector, comprising of a heterojunction build of inorganic material (silicon) and organic material (fullerene), as well as a cooling element (Peltier element). The inherent disadvantage of the above solution is the necessity of using a cooling element, providing a temperature sufficient for the phenomenon of photogeneration in silicon/fullerene heterojunction to occur.

The goal of the solution according to the invention is a device for transforming infrared radiation into electrical current or electrical voltage, featuring an organic layer that is an organic dye, which does not require any form of cooling. The device - a photodetector works at room temperature and exhibits a satisfying sensitivity level of generated photocurrent.

The device for transforming infrared radiation into electrical current or electrical voltage that constitutes a hybrid semiconductor photodiode, comprises a heterojunction between inorganic semiconducting material, for example silicon, and a semiconducting organic material, as well as appropriate metal electrodes providing an electrical contact of each of the parts of the junction with external electrical circuit separately. The characteristic feature of the said device is the fact that the organic material is Quinacridone (5,12-Dihydro-quino[2,3-b]acridine-7,14-dione).

It is preferable, that the top metal electrode connecting the organic layer with external electrical circuit features an area equal to or smaller than 1mm².

A method of fabrication of the said device, in which the organic layer is being deposited onto the silicon substrate, is characterized by a fact that the organic layer is deposited by evaporation in a vacuum chamber by a process of hot-wall-epitaxy (HWE), and the evaporation is preceded by thermal annealing of the substrate in the chamber under high vacuum conditions at temperature of 610°C, for the duration of 10 min.

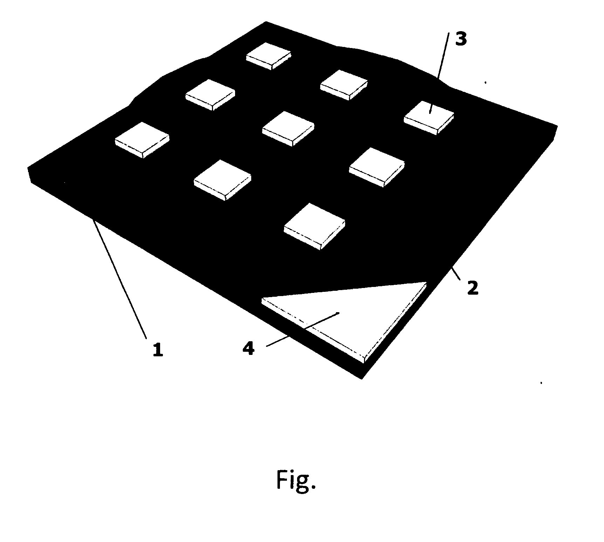

An example of the realization of the invention is depicted on the Figure, showing schematically the following parts of the device.

The device for transforming infrared radiation into electrical current or electrical voltage, especially working at room temperature, consists of a hybrid heterojunction, build of a substrate that is a semiconducting inorganic material 1 (for example silicon), semiconducting organic material 2 and suitable metal contacts: top metal electrode 3 and back metal electrode 4, contacting each of the layers with external electrical circuit separately.

Essential for obtaining satisfying parameters of the photodetector are two conditions:

For obtaining a satisfying sensitivity in the near infrared spectral range, and most of all for allowing the operation at room temperature without cooling, it is essential to use appropriate materials for organic layer, for example Quinacridone (5,12-Dihydro-quino[2,3-b]acridine-7,14-dione).

Second condition essential for obtaining a satisfying response time of the detector, is the use of a top electrode metal contact, connecting the organic layer with the external electrical circuit, featuring an area equal to or smaller than 1mm². Such an area provides a low capacitance of the diode, thus, a low RC constant of the device, which is directly lowering the response time of the photodiode, improving its frequency band.

The said device, defined above, with appropriately chosen components, allows for light detection in the near infrared and infrared spectral range, at room temperature, without cooling required. The detection of light is possible due to light absorption at the heterojunction. Significant feature is a possibility of light absorption for wavelengths that are not absorbed by each of the heterojunction components measured separately that is in the spectral range in which both used inorganic and organic materials are transparent. Due to the transparency of both materials in the discussed spectral range, in a typical realization of the device, infrared light is incident from the side of the silicon substrate, and afterwards is absorbed in the physical region of the junction (at the interface).

The absorption of light for wavelengths above the absorption edge of both used materials (i.e. for photons with energies lower than the bandgap of both used materials) is possible via photoexcitation of charge carriers from the inorganic semiconductor into the organic one. It is possible that the photoexcitation is realized via localized trap states, with energies within the bandgap of the organic material, situated in the organic material in the close proximity of the hybrid interface.

For obtaining a rectifying heterojunction (a diode) enabling the above described process of charge carrier photoexcitation, it is necessary to chose two materials with opposite type of conduction, for example a hole conducting p-type doped silicon and electron conducting n-type organic material. In that case a photoexcitation of an electron from the valence band of the silicon, close to the surface of the interface occurs, with a subsequent injection into the conduction band of the organic material (i.e. into the lowest unoccupied molecular orbital (LUMO) level). The photoexcitation undergoes possibly via an intermediate step that is a localized sub-bandgap state, situated in the organic material in the close proximity of the hybrid interface. At short circuit condition (no external bias applied) or under reverse bias, the photogenerated electron is being transported by an internal electric in the direction of the top metal electrode and further into the external circuit, simultaneously a hole in the inorganic material is being transported in the direction of the second electrode, allowing for the current in the external circuit to flow.

The method of the fabrication of the said device for transforming infrared radiation into electrical current of electrical voltage, especially working at room temperature, is realized by an appropriate technique of a deposition of the organic material on the silicon substrate. The proposed method includes evaporation in a vacuum chamber by a process of hot-wall-epitaxy (HWE), and the evaporation is preceded by thermal annealing of the substrate in the chamber under high vacuum conditions at temperature of 610°C, for the duration of 10 min.

The invention can be applied for light detection in the near infrared and infrared spectral range in optical data transmission, quality control, and industrial process control in which infrared is used to detect various substances.

Due to a hybrid construction of the heterojunction consisting of an organic material deposited directly on a silicon substrate, the invention will allow for a straightforward integration of the photodetector with a silicon IC, providing further processing and electrical amplification of the photoelectrical signal. It will also allow for integration with CMOS-type array of detectors. The ease of integration with established and mature silicon IC technologies will drastically diminish costs and complexity of manufacturing an end-product photodetector. Moreover, a further advantage is a circumvention of use of toxic compound semiconductor materials, consisting of arsenic, cadmium, or other hazardous elements.

The said device proposed in the invention, consisting of a layer of organic material from a group of organic dyes, does not require any form of cooling, and works at room temperature. The said device is characterized by a satisfying level of the generated photocurrent. The reason behind a high sensitivity and operation at room temperature is as well the method of device fabrication by evaporation, which allows for obtaining a layer of superior purity and higher degree of structural arrangement than in the case of spin coating of PCBM fullerene on the top of silicon substrate, described in AT 50381B1.

The example realization of the device, described above, consists of a configuration of layers, in which the inorganic material is p-type, whereas the organic one is n-type. However, an opposite configuration is as well feasible, in which the inorganic material is n-type, whereas the organic material is p-type and the expected photogeneration happens analogously.

## Claims

1. The device for transforming infrared radiation into electrical current or electrical voltage, especially working at room temperature according the invention that constitutes a hybrid semiconductor photodiode comprising of a combination of inorganic semiconducting material, for example silicon, and a semiconducting organic material, as well as appropriate metal electrodes providing an electrical contact of each of the parts of the junction with external electrical circuit separately **is characterized in that**, the organic material **(2)** is Quinacridone (5,12-Dihydro-quino[2,3-b]acridine-7,14-dione).

2. The device according to claim 1, **wherein** top metal electrode **(3)** connecting the said organic layer **(2)** with the external electric circuit, has an area of 1mm² or lower.

3. The method of fabrication of the device for transforming infrared radiation into electrical current or electrical voltage, especially working at room temperature, in which the organic layer **(2)** is being deposited onto the said silicon substrate **is characterized in that**, the deposition of the organic layer **(2)** is realized by evaporation in a vacuum chamber by a process of hot-wall-epitaxy (HWE), and the evaporation is preceded by thermal annealing of the said silicon substrate in the chamber under high vacuum conditions at temperature of 610°C, for the duration of 10 min.
